# DEMANDE DE BREVET EUROPEEN

(11) **EP 2 149 912 A1**
(43) Date de publication de la demande: **03.02.2010**
(21) Numéro de dépôt: 09166694.1
(22) Date de dépôt: 29.07.2009
(51) Int. Cl.: H01L 31/0352, H01L 31/173, H01S 5/026

(54) **Procédé de fabrication d'un dispositif optique d'analyse comportant un laser à cascades quantiques et un détecteur quantique**

(30) Priorité: 01.08.2008 FR 0804413
(71) Demandeur: Thales, 92200 Neuilly Sur Seine (FR)
(72) Inventeur: Berger, Vincent, 94200, IVRY (FR); Carras, Mathieu, 94250, GENTILLY (FR)
(74) Mandataire: Esselin, Sophie

(57) **Abrégé**

L'invention concerne un procédé de fabrication d'un dispositif optique d'analyse d'une scène comportant un émetteur et un détecteur dans le moyen ou lointain infrarouge **caractérisé en ce qu**'il comprend :
- la réalisation d'un empilement de couches semiconductrices épitaxiées à la surface d'un substrat semiconducteur dont certaines sont dopées ;
- la réalisation d'un premier dispositif d'émission dans le moyen ou lointain infrarouge de type laser à cascades quantiques (L) émettant un faisceau d'analyse, à partir d'un premier niveau dit niveau d'émission dans l'empilement de couches semiconductrices;
- la réalisation d'un second dispositif de détection (D) de type détecteur quantique capable de détecter un faisceau rétrodiffusé par la scène à analyser, au même niveau de l'empilement que le niveau dit d'émission.

## Description

Le domaine de l'invention est celui des dispositifs de détection à distance dans le moyen ou lointain infrarouge de type spectroscopie.

Actuellement, il existe des systèmes optiques de détection d'entités particulières type molécules présentes dans un environnement donné, par exemple des molécules de gaz, utilisées pour le contrôle de procédé, le contrôle de l'environnement, ou l'analyse médicale, qui emploient un laser et un détecteur.

Il existe notamment des dispositifs couramment dénommés LIDAR (Light Detection And Ranging) à rétrodiffusion représentant des systèmes clés dans la détermination de la distribution spatiale et des propriétés optiques des aérosols et des nuages. Ces informations sont fondamentales dans de nombreuses applications de laboratoire ou de terrain liées à la météorologie et à l'environnement.

Selon les systèmes, le laser peut être dans le visible, le proche infrarouge ou le moyen infrarouge. La lumière émise traverse le gaz à analyser, éventuellement dans une cavité résonnante, et le détecteur analyse la lumière transmise. On distingue la détection photo-acoustique et la détection de la lumière directement atténuée par le gaz. Dans tous les cas, le laser et le détecteur sont des dispositifs distincts, produits dans des filières technologiques différentes.

Un défaut essentiel de ces systèmes de détection est qu'ils sont constitués d'un assemblage de composants (laser, cavité ou miroirs, détecteur) relativement complexe à fabriquer, assembler et mettre en oeuvre.

Certaines solutions hybrides permettent d'obtenir une robustesse et une mise en oeuvre plus faciles. Par exemple la détection photo-acoustique ne nécessite pas de détecteur optique mais simplement un microphone.

Cette solution reste cependant un assemblage de composants et limite les fonctionnalités (pas d'imagerie possible).

C'est pourquoi dans ce contexte, la présente invention propose d'intégrer le détecteur et la source laser dans un dispositif monolithique durant la conception du composant.

Plus précisément l'invention a pour objet un procédé de fabrication d'un dispositif optique d'analyse d'une scène comportant un émetteur et un détecteur dans le moyen ou lointain infrarouge **caractérisé en ce qu**'il comprend :
- la réalisation d'un empilement de couches semiconductrices épitaxiées à la surface d'un substrat semiconducteur dont certaines sont dopées ;
- la réalisation d'un premier dispositif d'émission dans le moyen ou lointain infrarouge de type laser à cascades quantiques (LCQ) émettant un faisceau d'analyse, à partir d'un premier niveau dit niveau d'émission dans l'empilement de couches semiconductrices ;
- la réalisation d'un second dispositif de détection de type détecteur quantique capable de détecter un faisceau rétrodiffusé par la scène à analyser, au même niveau de l'empilement que le niveau dit d'émission.

Selon une variante de l'invention, le faisceau d'analyse est orienté en direction de la scène.

Selon une variante de l'invention, le procédé comprend en outre la réalisation d'un dispositif de type oscillateur local, pour effectuer une détection hétérodyne.

Selon une variante de l'invention, le faisceau d'analyse est partiellement orienté en direction de la scène et partiellement orienté en direction du détecteur.

Selon une variante de l'invention, le faisceau d'analyse est orienté en direction du dispositif de détection, la détection hétérodyne étant réalisée par interférence d'un signal optique d'analyse et d'un signal optique généré par la scène à analyser.

Selon une variante de l'invention, les premier et second dispositifs sont réalisés au sein d'un empilement unique de couches par une opération de gravure au sein dudit empilement de couches semiconductrices.

Selon une variante de l'invention, les premier et second dispositifs sont réalisés au même emplacement dans l'empilement de couches semiconductrices et sont activés successivement par des moyens de contrôle spécifiques.

Selon une variante de l'invention, le procédé comporte en outre la réalisation d'un dispositif de couplage diffractant sur le laser à cascades quantiques permettant de faire sortir la lumière à incidence normale au plan des couches semiconductrices.

Selon une variante de l'invention, le procédé comporte en outre la réalisation d'un dispositif de couplage diffractant sur le détecteur quantique permettant de coupler la lumière à incidence normale au plan des couches semiconductrices.

Selon une variante de l'invention, le dispositif optique obtenu par le procédé est destiné à analyser des espèces gazeuses.

L'invention a aussi pour objet procédé de fabrication d'un système d'imagerie comportant la réalisation d'une matrice de dispositifs optiques d'analyse selon l'invention, répartis de manière matricielle à la surface d'un substrat semiconducteur.

L'invention a encore pour objet un procédé de fabrication d'un système d'analyse multispectrale comportant la réalisation d'un ensemble de dispositifs optiques d'analyse selon l'invention et **caractérisé en ce que** chaque dispositif émet à une longueur d'onde spécifique.

Selon une variante de l'invention, la variation de longueur d'onde spécifique est obtenue par une variation des caractéristiques de chaque dispositif d'émission.

L'invention sera mieux comprise et d'autres avantages apparaîtront à la lecture de la description qui va suivre donnée à titre non limitatif et grâce aux figures annexées parmi lesquelles :
- les figures 1a à 1f schématisent un ensemble de configurations possibles de dispositif optique d'analyse obtenues selon le procédé de l'invention ;
- la figure 2 illustre un premier exemple de dispositif optique d'analyse obtenu selon le procédé de l'invention, dans lequel les dispositifs émetteur et détecteur sont séparés spatialement ;
- la figure 3 illustre un second exemple de dispositif optique d'analyse obtenu selon le procédé de l'invention dans lequel, les dispositifs émetteur et détecteur sont assurés dans un même emplacement ;
- la figure 4 illustre un troisième exemple de l'invention dans lequel est réalisé un oscillateur local intégré au dispositif d'émission permettant une détection hétérodyne ;
- la figure 5 illustre un troisième exemple de dispositif optique d'analyse obtenu selon le procédé de l'invention et comportant un laser dissocié du dispositif d'émission permettant une détection hétérodyne.

L'invention va être décrite dans le cadre de la détection de molécules de gaz mais pourrait s'appliquer tout aussi bien à la détection d'autres types d'espèces moléculaires dans un milieu donné, ou à l'analyse de tout type de surface, de scène dont on veut extraire des informations à partir d'un faisceau rétrodiffusé par ladite scène.

De manière générale, le procédé de fabrication de l'invention permet d'élaborer un dispositif intégré simple et robuste comparé aux systèmes actuels et repose sur la maîtrise bien établie de croissance épitaxiale de matériaux III-V.

II consiste à utiliser cette croissance dont le process technologique permet de réaliser une technologie LIDAR intégrée comportant au moins un émetteur et un détecteur intégré en un même composant.

Le procédé de fabrication du dispositif de détection selon l'invention permet d'élaborer sur un même substrat semiconducteur, une structure telle qu'elle fonctionne en tant que laser à cascade quantique LCQ et en tant que détecteur quantique pouvant avantageusement être à cascade quantique DCQ.

Selon l'invention, il peut également être prévu de créer une fonction d'oscillateur local au sein de l'empilement.

En effet, pour augmenter la sensibilité du dispositif, le détecteur peut être utilisé en mode hétérodyne, permettant de réduire fortement les problèmes de signal/bruit. Dans ce cas, un laser à cascade quantique sert d'oscillateur local dénommé OL en éclairant le détecteur, selon les principes de la détection hétérodyne décrits dans la littérature.

De manière générale, dans un système hétérodyne, le signal incident de fréquence fs et le signal de référence de fréquence f₀ (provenant d'un oscillateur local) sont mélangés dans un élément non-linéaire (mélangeur ou mixer). Ces signaux de fréquences proches sont récupérés à la sortie d'un mélangeur à une fréquence plus basse, dite fréquence intermédiaire que l'on peut amplifier plus facilement que les hautes fréquences de départ. Les analyseurs de spectre sont alors capables d'analyser le signal abaissé en fréquence avec une très grande précision en amplitude et en fréquence.

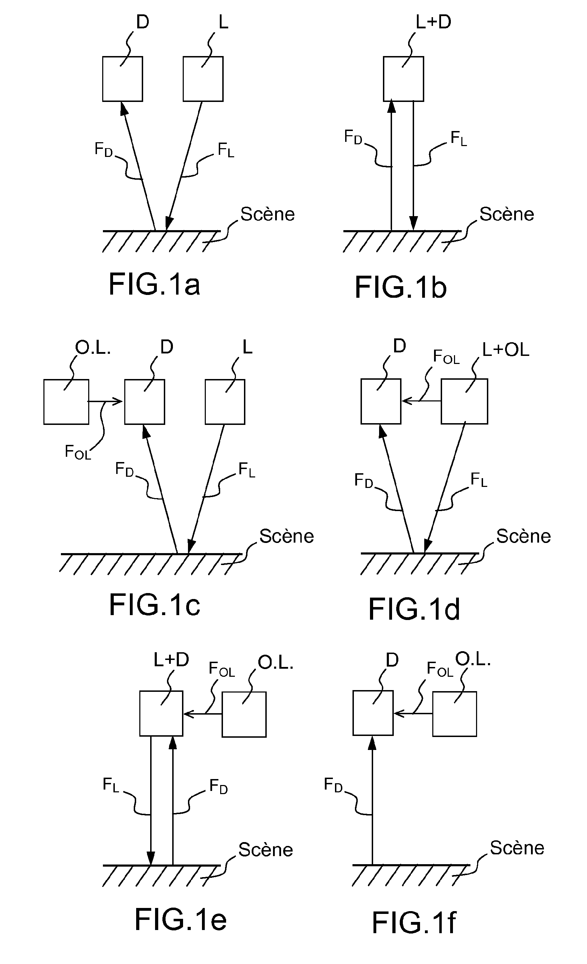

L'ensemble des figures 1a à 1f illustrent différentes configurations possibles décrivant l'ensemble des dispositifs d'émission et de détection élaborés dans l'empilement de couches semiconductrices.

Le schéma 1a est relatif à une configuration dans laquelle les dispositifs d'émission L et de détection D sont réalisés de manière à être dissociés au niveau de l'empilement de couches semiconductrices, le faisceau d'analyse F_{L} étant envoyé directement en direction de la scène à analyser, le détecteur recueillant un faisceau rétrodiffusé F_{D} par ladite scène.

Le schéma 1b est relatif à une configuration dans laquelle, les dispositifs d'émission et de détection sont réalisés au même emplacement de l'empilement et sont activés par des moyens de contrôle appropriés.

Le schéma 1c est relatif à une configuration comportant un oscillateur local OL, source annexe d'émission qui envoie un faisceau optique F_{OL} en direction du détecteur de manière à faire interférer le faisceau F_{D} issu de la scène avec le faisceau F_{OL}.

Le schéma 1d est relatif à une configuration dans laquelle le même emplacement de l'empilement de couches semiconductrices permet de créer les dispositifs d'émission et d'oscillateur local. Ainsi une partie de l'émission F_{L} est envoyée en direction de la scène et une autre partie de l'émission F_{OL} est envoyée vers le détecteur.

Le schéma 1e est relatif à une configuration dans laquelle un oscillateur local OL est une source annexe délivrant un faisceau optique F_{OL} en direction des dispositifs d'émission L et de détection D réalisés au même emplacement de l'empilement et activés par des moyens de contrôle appropriés.

Le schéma 1f est relatif à une configuration dans laquelle, le dispositif d'émission joue le rôle d'oscillateur local et émet un faisceau optique F_{OL} en direction du détecteur D, la détection hétérodyne étant réalisée par interférence du faisceau optique F_{OL} et du signal optique F_{D} provenant directement de la scène à analyser.

De manière générale et selon le procédé de l'invention, on procède à l'élaboration d'un empilement de couches semiconductrices.

Pour cela, il est proposé de faire croître sur un substrat semiconducteur pouvant assurer en lui-même une fonction d'électrode ou recouvert d'une couche assurant cette fonction, un empilement de couches semiconductrices dont certaines sont dopées de manière adaptée pour les fonctions recherchées.

Typiquement, l'empilement comporte une couche de confinement inférieur, une région à gain, une couche de confinement supérieure et une électrode supérieure.

Plus précisément, le laser à cascade quantique comportent deux électrodes pour appliquer un champ électrique de commande, un guide d'ondes disposé entre les électrodes et une structure comprenant une région à gain formée de plusieurs couches qui comprennent une alternance de strates d'un premier type définissant chacune une barrière quantique et de strates d'un second type définissant chacune un puits quantique, ces strates étant constituées de premier et second matériaux semiconducteurs, respectivement constitutifs des barrières et des puits.

La structure comporte en outre deux couches de confinement optique disposées de part et d'autre de la région à gain. La surface supérieure de la région de confinement supérieur peut former un réseau optique destiné à sélectionner une longueur d'onde déterminée à l'intérieur de la bande de longueurs d'ondes émises dans la région à gain. Ce type de laser est appelé laser à « réaction distribuée » de l'anglais « distributed feedback » (DFB) laser et trouve notamment des applications dans le domaine de la spectroscopie d'absorption de gaz.

Les matériaux constitutifs des barrières et des puits sont choisis de manière à ce qu'ils présentent une maille égale à celle du substrat, de façon à conserver la structure monocrostalline dans toute l'épaisseur du laser.

La région à gain est elle-même constituée d'une pluralité de couches constituant des puits et des barrières quantiques, et formant une zone dans laquelle peuvent s'effectuer des transitions électroniques inter-sous-bandes.

Plus précisément, les électrons transitant d'une électrode à l'autre passent d'une sous-bande à une autre sous-bande dans la région à gain en émettant des photons, selon un procédé connu de la littérature, constituant par la même le laser d'émission capable d'émettre un faisceau incident d'analyse d'espèces gazeuses données.

Pour détecter des espèces gazeuses présentant une raie d'absorption dans une gamme de fréquence centrée sur une fréquence ω_{gaz}, on choisit des paramètres de structure tels qu'il permettent que le laser à cascades quantiques génère des impulsions de fréquence dans une gamme de fréquence [ω₁ ; ω₂] comprenant la fréquence ω_{gaz}, sous l'application d'un champ électrique approprié.

L'analyse d'un gaz nécessite que la longueur d'onde du détecteur soit précisément définie. C'est pourquoi, selon l'invention une technologie de type détecteur à cascades quantiques DFB est particulièrement bien adaptée pour assurer la fonction détection.

Dans ce cas, la longueur d'onde du LCQ est accordée sur une raie d'absorption du gaz à analyser, et cette longueur d'onde peut subir une variation pendant une durée de pulse d'alimentation électrique du LCQ, de manière à couvrir spectralement la raie d'absorption du gaz, selon un principe connu dans la littérature.

On peut aussi utiliser une géométrie de type cavité externe pour le LCQ selon un principe connu de la littérature.

### Exemples de procédé de fabrication de dispositifs d'analyse optique selon l'invention :

De manière générale, l'empilement de couches est effectué par des procédés d'épitaxie classique de type MOCVD, MBE,...

Les dispositifs d'émission ainsi élaborés émettent dans des domaines de longueurs d'onde de l'ordre de 1 à 300 microns, c'est à dire toutes les longueurs d'onde accessibles par les LCQ.

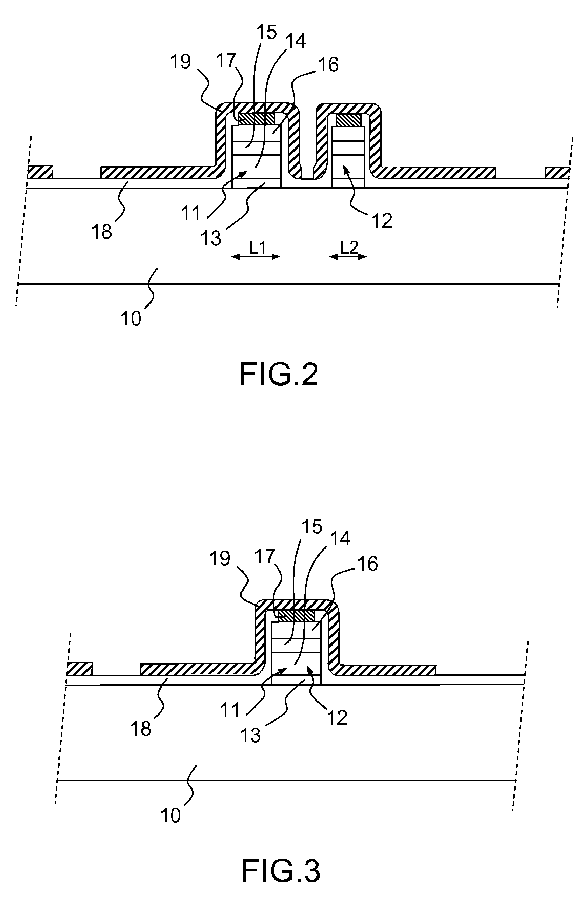

Selon une variante de l'invention, le laser et le détecteur sont deux composants réalisés à partir du même empilement de couches épitaxiées. Ils sont physiquement séparés spatialement par une opération de gravure comme illustré en figure 2. Plus précisément, à la surface d'un substrat semiconducteur 10, sont réalisées les deux dispositifs d'émission 11 et de détection 12 respectivement de largeur L1 et L2 (typiquement L1 peut être comprise entre 5 et 30 µm et L2 peut être de l'ordre de quelques dizaines de microns jusqu'à 1 mm).

Ces empilements de couches en matériau semiconducteur comportent chacun à partir du substrat 10, une couche de confinement inférieure 13, une région à gain 14, une couche de confinement supérieure 15 et une électrode supérieure 16. L'électrode supérieure 16 est recouverte d'une couche de contact métallique 17. Avantageusement, il est prévu une couche de passivation 18 permettant d'éviter tout court-circuit entre les électrodes inférieure et supérieure. Une couche de contact métallique 19 peut également être prévue, destinée au soudage de fils électriques.

Selon une autre variante de l'invention, le laser et le détecteur sont réalisés spatialement au même endroit de l'empilement, les deux types de fonction d'émission et de détection étant obtenues séquentiellement par commande en tension, comme illustré en figure 3. Les structures 11 et 12 sont réalisées au sein du même emplacement.

II peut être avantageux de faire sortir la lumière à incidence normale au plan des couches semi-conductrices, en utilisant un dispositif de couplage diffractant sur le LCQ.

On peut assembler différents dispositifs ainsi constitués et définis par une structure LCQ, une structure DCQ et un oscillateur local OL pour constituer une matrice de lidars. L'ensemble permet ainsi de réaliser un système d'imagerie et/ou un système d'analyse multispectrale.

Dans le cas de l'imagerie, chaque dispositif élémentaire analyse une direction de l'espace grâce à un système de couplage optique.

Dans le cas de l'analyse multispectrale, chaque dispositif émet à une longueur d'onde spécifique. Ceci peut être obtenu en variant le pas du DFB d'un dispositif à l'autre lors de la réalisation du LCQ.

La taille totale d'un dispositif pouvant être inférieure à un millimètre, des systèmes matriciels contenant un grand nombre de dispositifs peuvent être réalisés sur un même substrat.

Eventuellement la même structure de laser à cascades quantiques LCQ peut servir de source laser et d'oscillateur local en même temps comme illustré en figure 3.

Par exemple, le rayonnement laser sorti d'une face d'un ruban réalisé par gravure de l'empilement de couches semiconductrices du LCQ sert de sonde vers l'extérieur et le rayonnement laser issu de l'autre face du LCQ joue le rôle d'oscillateur local éclairant le DCQ.

Pendant un pulse de courant, la longueur d'onde du LCQ varie à cause du réchauffement de la diode. Notons cette longueur d'onde I(t). La longueur d'onde qui éclaire le DCQ est I(t), et le rayonnement du LCQ qui a sondé l'espace extérieur à analyser et qui revient sur le détecteur au même instant a une longueur d'onde I(t-dt), où dt est l'intervalle de temps qu'a mis la lumière pour faire l'aller du composant vers l'espace extérieur à analyser et le retour vers le composant. Le décalage en longueur d'onde entre I(t) et I(t+dt) permet, par détection hétérodyne, de mesurer le délai dt et donc de faire une analyse de type lidar.

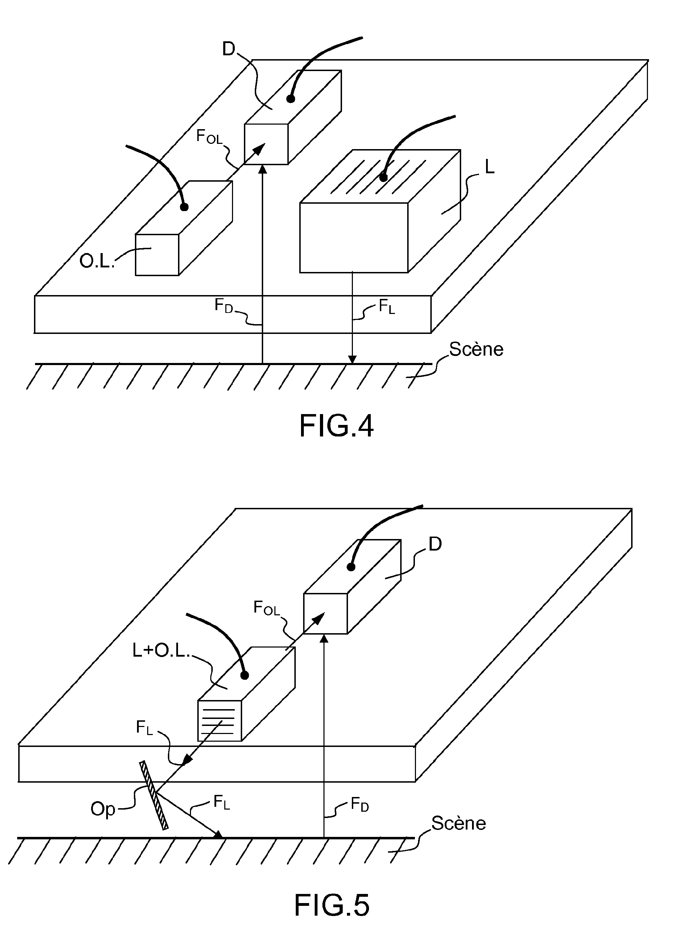

II est tout aussi possible selon le procédé de réalisation de l'invention, de dissocier au niveau de l'empilement des couches semiconductrices, les dispositifs d'émission, de détection et d'oscillateur local comme représenté en figure 4.

Le dispositif d'émission L émet un faisceau d'analyse en direction de la scène, l'oscillateur local émet un faisceau F_{OL} annexe en direction du détecteur selon une direction parallèle au plan de l'empilement.

Le signal optique depuis la scène F_{D} et correspondant au faisceau rétrodiffusé issu du faisceau d'analyse F_{L}, interfère avec ledit faisceau F_{OL}.

Selon une autre variante de l'invention, il est également possible de réaliser simultanément les émissions du dispositif laser et celle de l'oscillateur local à partir de la même mesa dans l'empilement de couches semiconductrices comme illustré en figure 5. Les deux faces opposées sont ainsi dédiées aux deux types d'émission et permettent l'émission des faisceaux F_{L} et F_{OL}. Un système optique Op permet d'acheminer le faisceau dédié à l'émission en direction de la scène à analyser de manière à pouvoir faire interférer au niveau du détecteur D, les faisceaux F_{D} issu de F_{L} et F_{OL}.

## Revendications

1. Procédé de fabrication d'un dispositif optique d'analyse d'une scène comportant un émetteur et un détecteur dans le moyen ou lointain infrarouge **caractérisé en ce qu'**il comprend :
- la réalisation d'un empilement de couches semiconductrices épitaxiées à la surface d'un substrat semiconducteur dont certaines sont dopées ;
- la réalisation d'un premier dispositif d'émission dans le moyen ou lointain infrarouge de type laser à cascades quantiques (L) émettant un faisceau d'analyse, à partir d'un premier niveau dit niveau d'émission dans l'empilement de couches semiconductrices;
- la réalisation d'un second dispositif de détection de type détecteur quantique (D) capable de détecter un faisceau rétrodiffusé par la scène à analyser, au même niveau de l'empilement que le niveau dit d'émission.

2. Procédé de fabrication d'un dispositif optique d'analyse selon la revendication 1, **caractérisé en ce que** le faisceau d'analyse est orienté en direction de la scène.

3. Procédé de fabrication d'un dispositif optique d'analyse selon l'une des revendications 1 à 2, **caractérisé en ce qu'**il comprend en outre la réalisation d'un troisième dispositif de type oscillateur local (OL), pour effectuer une détection hétérodyne.

4. Procédé de fabrication d'un dispositif optique d'analyse selon la revendication 3, **caractérisé en ce que** le faisceau d'analyse est partiellement orienté vers la scène et partiellement orienté en direction du détecteur.

5. Procédé de fabrication d'un dispositif optique d'analyse selon la revendication 3, **caractérisé en ce que** le faisceau d'analyse est orienté en direction du dispositif de détection, la détection hétérodyne étant réalisée par interférence du faisceau d'analyse et d'un faisceau généré par la scène à analyser.

6. Procédé de fabrication d'un dispositif optique d'analyse selon l'une des revendications 1 à 5, **caractérisé en ce que** les premier et second dispositifs sont réalisés au sein d'un empilement unique de couches par une opération de gravure au sein dudit empilement de couches semiconductrices.

7. Procédé de fabrication d'un dispositif optique d'analyse selon l'une des revendications 1 à 6, **caractérisé en ce que** les premier et second dispositifs sont réalisés au même emplacement dans l'empilement de couches semiconductrices et sont activés successivement par des moyens de contrôle spécifiques.

8. Procédé de fabrication d'un dispositif optique d'analyse selon l'une des revendications 1 à 7, **caractérisé en ce qu'**il comporte en outre la réalisation d'un dispositif de couplage diffractant sur le laser à cascades quantiques permettant de faire sortir la lumière à incidence normale au plan des couches semiconductrices.

9. Procédé de fabrication d'un dispositif optique d'analyse selon l'une des revendications 1 à 8, **caractérisé en ce qu'**il comporte en outre la réalisation d'un dispositif de couplage diffractant sur le détecteur quantique permettant de coupler la lumière à incidence normale au plan des couches semiconductrices.

10. Procédé de fabrication d'un dispositif optique d'analyse selon l'une des revendications 1 à 9, **caractérisé en ce que** le dispositif optique est destiné à analyser des espèces gazeuses.

11. Procédé de fabrication d'un système d'imagerie comportant la réalisation d'une matrice de dispositifs optiques d'analyse, selon l'une des revendications 1 à 10, répartis de manière matricielle à la surface d'un substrat semiconducteur.

12. Procédé de fabrication d'un système d'analyse multispectrale comportant la réalisation d'un ensemble de dispositifs optiques d'analyse selon l'une des revendications 1 à 10 et **caractérisé en ce que** chaque dispositif émet à une longueur d'onde spécifique.

13. Procédé de fabrication d'un système d'analyse multispectrale selon la revendication 12, **caractérisé en ce que** la variation de longueur d'onde spécifique est obtenue par une variation des caractéristiques de chaque dispositif d'émission.
